# DEMANDE DE BREVET EUROPEEN

(11) **EP 0 564 315 A1**
(43) Date de publication de la demande: **06.10.1993**
(21) Numéro de dépôt: 93400669.3
(22) Date de dépôt: 16.03.1993
(51) Int. Cl.: H05K 7/20

(54) **Dispositif de refroidissement de circuit inductif**

(30) Priorité: 24.03.1992 FR 9203511
(71) Demandeur: THOMSON-CSF, 75008 Paris (FR)
(72) Inventeur: Besson, Guy Claude, F-92402 Courbevoie Cédex (FR); Bierry, Michel, F-92402 Courbevoie Cédex (FR); Geneau, Arnaud, F-92402 Courbevoie Cédex (FR)
(74) Mandataire: Lincot, Georges

(57) **Abrégé**

Le dispositif selon l'invention permet le refroidissement de circuits inductifs, notamment de circuits inductifs munis de circuits magnétiques en ferrite (3).

Dans une variante préférée de réalisation les spires de circuits inductifs sont réalisés au moyen des pistes métallisées d'un circuit imprimé multicouche (4). Des moyens (7) permettent d'appliquer une pression sur les circuits magnétiques (3) via une mousse (6) de répartition des contraintes de manière à ce que ceux-ci viennent en contact avec un joint thermique (2) à l'intérieur d'une structure d'accueil (1). Des glissières (8) permettent de bloquer le circuit imprimé (4) à l'intérieur de la structure d'accueil (1) et permettent son enfichage et son désenfichage, de façon aisée.

L'intérieur du circuit magnétique est muni d'une deuxième mousse (5) permettant son retrait libre à l'enfichage ou en désenfichage.

## Description

La présente invention concerne le domaine des circuits inductifs et plus particulièrement le refroidissement de ces circuits.

Dans le cadre de l'invention, on définit un circuit inductif comme étant un ensemble constitué d'un ou plusieurs enroulements comprenant une ou plusieurs spires chacun. D'autre part, cet ensemble comprend les supports de ce ou ces enroulements, les circuits magnétiques permettant de canaliser le flux magnétique induit par le fonctionnement électrique du circuit inductif et diverses pièces mécaniques de fixation.

En général, les circuits inductifs sont calculés pour évacuer naturellement les calories résultant des pertes par induction.

De façon plus précise, l'ensemble du circuit inductif est calculé de telle manière que l'échauffement de chacun des sous-ensembles qui le composent soit compatible avec les matériaux utilisés. Les fournisseurs de circuits magnétiques ne donnent que les bases de calcul en air ambiant car les matériaux ne sont pas conçus pour évacuer la chaleur par conduction, comme c'est le cas par exemple, pour les transistors ou autres composants semi-conducteurs de puissance.

Les circuits inductifs sont susceptibles d'un grand nombre d'application. On peut citer, à titre d'illustration, leur utilisation dans les alimentations en énergie électrique et tout particulièrement dans les alimentation du type "à découpage," onduleur ou d'un type fonctionnant selon un procédé analogue.

Dans ce type d'application, on cherche à augmenter les fréquences de commutation. Une des raisons majeures de ce choix est que plus la fréquence est élevée, plus le volume des circuits magnétiques peut être réduit. On en attend donc des réductions importantes en encombrement et en poids, ce qui permet une intégration plus poussée. Ces gains sont particulièrement appréciés si l'on vise, par exemple, le domaine du matériel embarqué.

En contrepartie, la montée en fréquence augmente les pertes dans le matériau magnétique. Cela restreint l'utilisation du circuit inductif évacuant naturellement la chaleur. On se trouve alors devant l'alternative suivante : ou bien les performances d'utilisation électriques doivent être réduites ou bien le volume du circuit inductif doit être augmenté. Dans tous les cas, la dissipation naturelle échauffe l'air ambiant, ce qui diminue les possibilités d'utilisation en enceinte fermée.

Pour les raisons qui viennent d'être rappelées l'évacuation calorifique naturelle s'avère donc insuffisante lorsqu'on vise les applications en haute fréquence, à puissance élevée.

On pourrait penser que la solution de ce problème consiste à mettre en contact le circuit magnétique avec une surface d'échange thermique comme dans le cas des composants semi-conducteurs de puissance. Si ce principe est simple, sa mise en pratique est délicate. En effet, les circuits magnétiques couramment disponibles n'ont pas été conçus dans ce but. En haute fréquence, on fait appel le plus souvent à des matériaux à base de ferrites. Ces matériaux sont fragiles. D'autre part, les circuits inductifs sont en général destinés à être soudés sur des circuits imprimés. Il est nécessaire de les munir d'un ensemble de pièces prévues à cet effet.

L'invention vise à pallier les défauts de l'Art Connu.

L'invention concerne un dispositif permettant d'exercer sur les circuits inductifs une pression sur une surface destinée à évacuer la chaleur, tenant compte des caractéristiques spécifiques de ces circuits qui viennent d'être rappelés.

En outre, les dispositions prises sont compatibles avec un usage industriel. En effet, elles ne doivent pas impliquer des manipulations longues et coûteuses lors du montage. Elles doivent également rendre aisée la maintenance des circuits, notamment lors du démontage.

L'invention a donc pour objet un dispositif de refroidissement d'au moins un circuit inductif disposé sur un support, ce support étant destiné à être inséré dans un réceptacle comportant des moyens permettant ledit refroidissement ; caractérisé en ce qu'il comprend des moyens commandables exerçant une force de pression sur chaque circuit inductif suivant une direction déterminée de manière à l'amener en contact avec une surface déterminée desdits moyens de refroidissement lorsque la pression est exercée et des moyens de répartition de contrainte, disposés entre lesdits moyens commandables et chaque circuit inductif, répartissant uniformément la pression sur une portion du circuit inductif.

L'invention sera mieux comprise et d'autres caractéristiques et avantages apparaîtront à l'aide de la description qui suit en référence aux figures annexées et parmi lesquelles :
- les figures 1 et 2 illustrent schématiquement le mécanisme mis en oeuvre pour exercer une pression sur un circuit inductif et le mettre en contact avec une surface d'échange thermique,
- la figure 3 illustre, de façon détaillée, la procédure d'insertion dans une structure de refroidissement d'un ensemble comprenant des circuits inductifs,
- les figures 4 et 5 illustrent, en coupe, deux positions de l'ensemble comprenant des circuits inductifs après insertion dans ladite structure,
- les figures 6 et 7 illustrent un des composants dudit ensemble,
- les figures 8 et 9 illustrent une variante supplémentaire de réalisation d'un dispositif selon l'invention.

Pour illustrer l'invention, on considérera dans ce qui suit, sans que cela soit limitatif, le cas d'une alimentation en énergie électrique fonctionnant selon le principe du "découpage à haute fréquence" ou selon un procédé analogue. Dans ce type d'alimentation, on utilise notamment des transformateurs et des selfs de filtrage. Pour fixer les idées, on supposera que la fréquence de découpage est de l'ordre du mégahertz et que les circuits inductifs sont réalisés selon l'enseignement de la demande de brevet français publiée sous le n° 2 641 438, le 6 juillet 1990.

Selon cette demande de brevet, les circuits inductifs sont des circuits planaires réalisés par, d'une part, des métallisations sélectives d'une ou plusieurs couches d'un circuit imprimé multicouche et, d'autre part, à l'aide de trous métallisés réalisant des jonctions entre ces couches.

Le noyau magnétique comporte deux parties disposées de part et d'autre du circuit imprimé et assemblées à l'aide, notamment, de brides de fixation.

Pour plus de détails, on se reportera avec profit à la description de cette demande de brevet illustrée par des figures annexées 1 à 3.

En complément des enseignements principaux de la demande de brevet français précitée, on va adopter dispositions spécifiques permettant d'exercer une pression sur une des faces des circuits magnétique, sans que cette pression soit destructrice. En d'autres termes, on tient compte du caractère de fragilité signalé des matériaux à base de ferrite et de façon plus générale de la spécificité des circuits inductifs par rapport à d'autres composants de puissance.

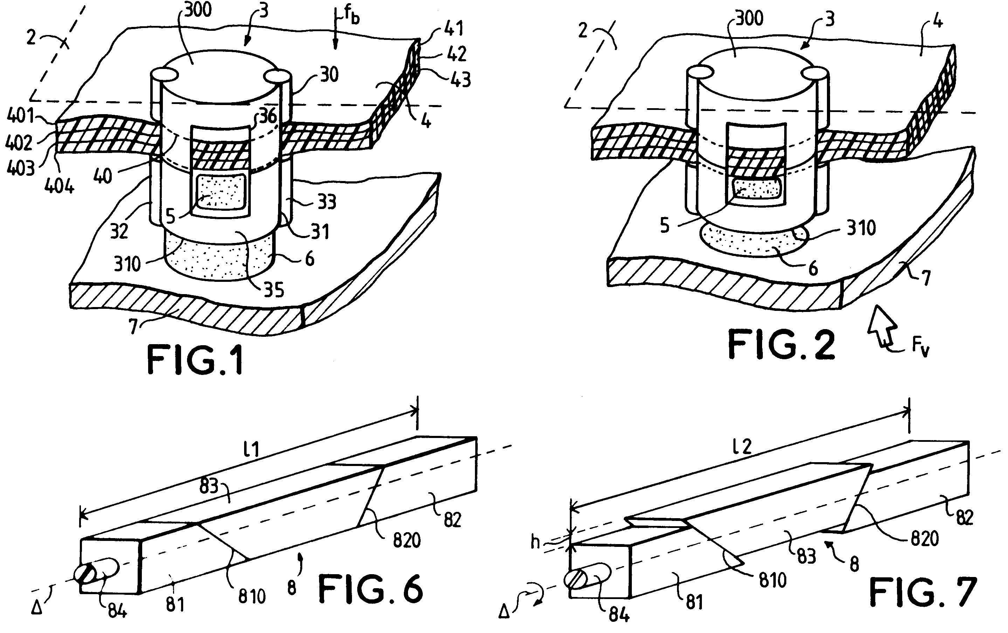

La figure 1 illustre une partie des dispositions retenues dans la cadre de l'invention pour atteindre cet objectif. Le circuit inductif a été réalisé, dans l'exemple illustré par métallisation sélective d'un circuit imprimé multicouche 4. Dans l'exemple de la figure 1, ce circuit imprimé 4 comprend trois couches 41, 42 et 43 ; ce dans un but de simplification. Un circuit imprimé réel peut comprendre un nombre de couches plus important, typiquement huit couches. Les quatre plans de métallisation possibles portent les références 401 à 404. Le dessin des spires n'a pas été représenté. On se reportera de nouveau avec profit à la demande de brevet français précitée et en particulier à la figure la qui donne un exemple de réalisation de spire.

Le circuit magnétique 3, à base de matériau en ferrite moulée, comprend deux demi-coques, 30 et 31, de forme circulaire ou quasi-circulaire. D'autre structures sont naturellement utilisables dans le cadre de l'invention. On a représenté également deux brides 32 et 33 permettant la fixation des deux demi-coques, 30 et 31, entre elles.

Le circuit imprimé 4 comporte un ajourage 40 suffisant pour permettre à l'ensemble des pièces 30 et 33 de coulisser librement suivant la direction verticale sur la figure 1 et de façon plus générale perpendiculairement aux plans que forme le circuit imprimé 4.

Le circuit magnétique 3 comportant des parties pleines, 34 et 35, c'est-à-dire les parties supérieure et inférieure, et des parties latérales évidées, telle la fenêtre 36, reste donc solidaire du circuit imprimé 4 tout en gardant un degré de liberté suivant une direction perpendiculaire au plan qui forme le circuit imprimé 4.

Des moyens de rappel 5 sont prévus pour, qu'en l'absence de pression exercée sur le circuit magnétique 3 (de bas en haut sur la figure 1), celui-ci se positionne spontanément dans un état que l'on appellera dans ce qui suit "position I".

En l'occurrence, les moyens 5 tendent à éloigner la partie 35, appelée inférieure dans l'exemple décrit, du circuit imprimé 4.

Tout moyen permettant d'obtenir ce résultat peut être utilisé. Il peut s'agir d'un ressort ou d'un moyen équivalent. Mais il faudra veiller à ce que le matériau utilisé, d'une part, ne court-circuite pas les spires éventuellement réalisées sur la couche de métallisation 404 et, d'autre part, ne perturbe pas l'écoulement du flux magnétique.

Dans une variante préférée de l'invention, on fait appel à un matériau à base de mousse ; par exemple sous la forme d'une rondelle de mousse 5 placée à l'intérieur du circuit magnétique 3, entre la partie inférieure 35 et le circuit imprimé 4. Cette rondelle exerce une force de rappel selon la direction de la flèche f_{b}.

Comme on le verra dans ce qui suit, il est prévu un organe presseur 7, sous la forme d'une plaque dans l'exemple illustré.

Selon une caractéristique importante de l'invention, cet organe presseur 7 agit sur le circuit magnétique 3 par l'intermédiaire d'un élément 6 répartissant la pression uniformément les contraintes ; en l'occurrence sur la face inférieure 310 du circuit magnétique 3.

Cette action est illustrée plus particulièrement par la figure 2. Si on exerce une force sur la plaque 7, de bas en haut, suivant une direction parallèle à la flèche Fᵥ, l'élément 6 va s'écraser tout en soulevant le circuit magnétique 3 dont la face supérieure 300 va entrer en contact avec une surface 2 permettant l'échange thermique.

Simultanément, la mousse 5 va s'écraser elle aussi et permettre la translation vers le haut du circuit magnétique 3.

L'ensemble de ces actions va permettre un contact progressif entre le circuit magnétique 3 et ladite surface 2. Le circuit magnétique 3 se trouve alors en "position II" ou position opérationnelle.

Comme en ce qui concerne les moyens 5, les moyens 6 sont préférentiellement réalisés à l'aide de matériau à base de mousse. Ils peuvent être simplement constitués par une rondelle en mousse 6, collée sur la face inférieure 310 du circuit magnétique 3. Ce matériau est particulièrement bien adapté pour répartir de façon uniforme les contraintes exercées

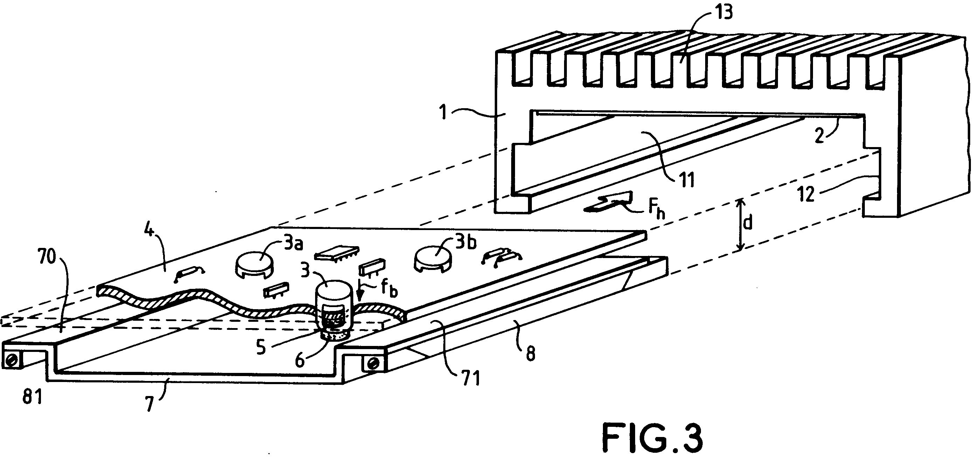

La figure 3 illustre de façon plus précise le mécanisme d'insertion d'un ensemble comprenant au moins un circuit inductif selon l'invention dans une structure d'accueil 1 ou réceptable. Celle-ci permet le refroidissement des circuits inductifs. Le circuit inductif comprend un circuit magnétique 3 muni de deux rondelles 5 et 6, à base de matériau en mousse.

L'ensemble illustré comprend, outre le circuit magnétique 3, deux autres circuits magnétiques, 3a et 3b, et divers composants électroniques non référencés. Tous ces composants sont supportés par un circuit imprimé multicouche 4 dans lequel sont réalisés les circuits inductifs associés aux circuits magnétiques 3, 3a et 3b.

Le circuit imprimé 4 a été représenté en coupe partielle pour mieux illustrer le mécanisme d'insertion selon l'invention. On voit sur la figure 3 que les moyens de rappel 5, réalisés de façon préférentielle à l'aide d'une rondelle de mousse, exercent une pression sur le fond du circuit magnétique 3, selon la direction de la flèche f_{b}. Cette action entraîne, via les moyens de répartition de contrainte 6, l'éloignement de la plaque 7 du circuit imprimé 4. Il en est de même pour les circuits magnétiques 3a et 3b.

Pour compléter l'ensemble, on a prévu deux glissières, référencées 8, disposées sur les parties latérales, droite et gauche, de la plaque 7. En réalité cette plaque 7 comporte deux ailes, 70 et 71, et a la forme d'un "U" évasé. Les glissières 8 sont disposées en dessous de ces ailes 70 et 71 de telle manière que l'épaisseur de l'empilement : glissière 8, plaque 7 et circuit imprimé 4, soit égal à une valeur d prédéterminée.

L'ensemble qui vient d'être décrit est destiné à être inséré dans une structure d'accueil 1 ou réceptable comportant deux rainures latérales de guidage 11 et 12 dont la hauteur est égale ou supérieure à ladite valeur d.

On voit que l'on peut aisément glisser l'ensemble précité dans ces rainures de guidage 11 et 12, en effectuant une translation suivant la direction symbolisée par la flèche Fₕ, direction horizontale sur la figure 3.

La partie supérieure de la structure d'accueil 1 comporte de façon avantageuse des rainures 13 ou d'autres dispositions jouant le rôle d'un radiateur et permettant un échange calorifique plus intense avec le milieu ambiant extérieur. Sur sa face interne, un joint thermique 2 est prévu. Il est destiné à répartir uniformément la conduction thermique et les contraintes mécaniques sur les circuits magnétiques 3, 3a et 3b, après insertion.

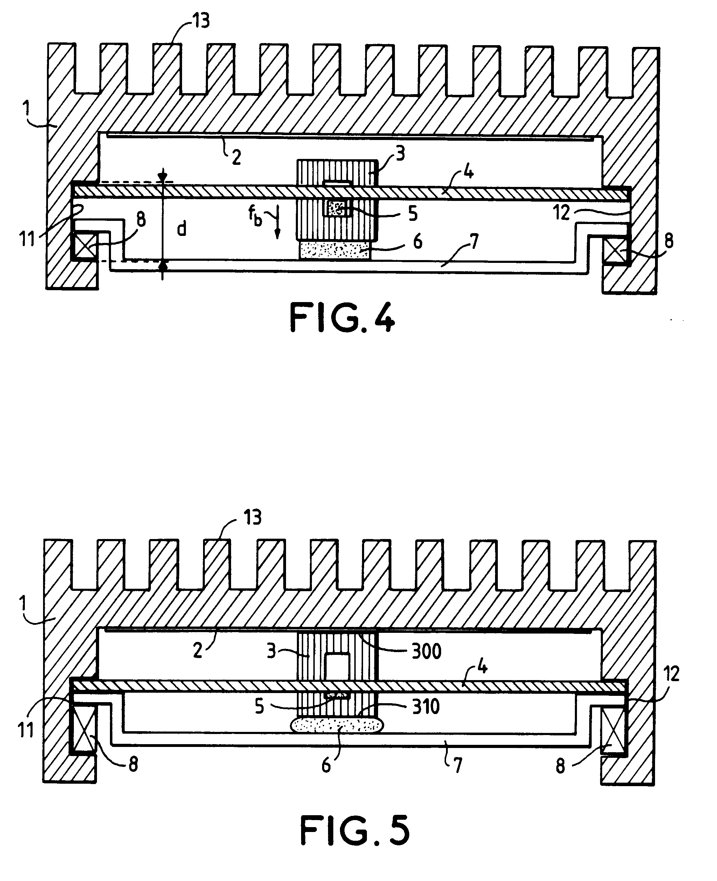

La figure 4 illustre, en coupe, le dispositif selon l'invention après insertion, en position d'enfichage/désenfichage ou "position I".

On voit que le circuit magnétique 3 (mais aussi les circuits magnétiques 3a et 3b non visibles sur cette figure) est en position basse du fait de la pression exercée suivant la flèche f_{b} par l'élément de rappel 5. La hauteur d des rainures de guidage 11 et 12 étant suffisante pour que l'ensemble puisse glisser librement, comme il a été décrit en relation avec la figure 3, l'élément 6 est également décompressé.

La figure 5 illustre le dispositif selon l'invention en position opérationnelle, c'est-à-dire en "position II".

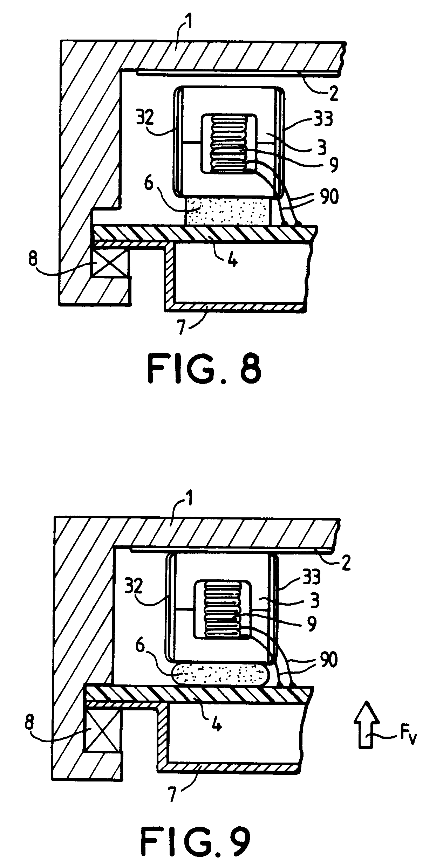

Pour ce faire, on soulève la plaque 7 à l'aide de moyens 8 que l'on appellera dans ce qui suit glissières. On verra ultérieurement, en relation avec les figures 6 et 7, un exemple de réalisation permettant d'arriver à ce résultat.

La plaque 7 exerce une pression sur l'élément 6 qui va s'écraser et répartir la pression sur la face inférieure 310 du circuit magnétique 3. Ce circuit 3 va se soulever et sa face supérieure 300 être mise en contact progressivement avec le joint thermique 2. Il en est de même pour les circuits magnétiques 3a et 3b (figure 3), non visibles sur cette figure.

Le dispositif selon l'invention permet donc d'exercer une force de pression sur chaque circuit magnétique, à répartition uniforme et dont l'action est progressive. En outre, la pression est également repartie uniformément entre les divers circuits magnétiques, les disparités éventuelles étant absorbées par les moyens de pression 6 associés à chaque circuit magnétique.

Enfin l'action exercée par les glissières 8 a pour effet de bloquer le circuit imprimé 4 et la plaque presseuse 7 dans son logement, c'est-à-dire à l'intérieur de la structure d'accueil 1. L'ensemble se comporte comme une glissière dite à "force d'insertion nulle".

Les glissières 8 permettant simultanément le blocage/déblocage et la création d'une pression sur les circuits magnétiques 3, 3a et 3b, peuvent être réalisées très simplement.

Les figures 6 et 7 illustrent un exemple de réalisation préférée des moyens 8.

Chaque glissière 8 a la forme d'un barreau de section rectangulaire et comprend trois parties 81, 82 et 83. Un système 84, par exemple à vis, permet de rapprocher les deux pièces d'extrémité 81 et 82 en leur faisant effectuer une translation suivant un axe Δ, parallèle à la grande longueur du barreau.

Pour autoriser ce rapprochement, les faces communes 810 et 820 entre, d'une part, les pièces 81 et 83, et, d'autre part, les pièces 82 et 83 sont biseautées. Cette disposition permet à la pièce intermédiaire 83 de se soulever par glissement sur les faces biseautées.

Lorsque toutes les pièces 81 à 83 sont alignées, la longueur maximale du barreau est égale à l₁.

Lorsqu'à l'aide des moyens 84, comme illustré par la figure 7, on rapproche les pièces terminales 81 et 82, la longueur du barreau devient l₂<l₁, et la pièce intermédiaire 83 se soulève pour augmenter l'épaisseur du barreau de la valeur h. Par ce biais, on va exercer une pression sur le plateau 7 et le soulever jusqu'au blocage dans les gorges 11 et 12, conformément à ce qui a été décrit en relation avec les figures 4 et 5.

Il doit être clair que le mode de réalisation des moyens 8, qui ont été appelés glissières dans ce qui précède, n'est pas le seul possible. Tout moyen permettant d'exercer une pression sur le plateau 7 jusqu'au blocage de l'empilement "circuit imprimé 4 - plateau 7" dans la structure d'accueil 1 est utilisable dans le cadre de l'invention.

De façon plus générale, on appellera les moyens 8 moyens de translation du plateau 7.

On voit donc que l'invention atteint bien les buts qu'elle s'est fixée. Elle permet d'augmenter la puissance dissipée par les circuits inductifs. En outre, elle permet un maintien mécanique de ces circuits inductifs sans risque de détérioration de ceux-ci, mais aussi du circuit imprimé et des autres composants de puissance. On peut en effet profiter de la présence du joint thermique 2 pour refroidir des composants autres que les circuits magnétiques. Il suffit qu'ils soient positionnés de telle manière qu'ils rentrent en contact avec le joint thermique 2 lorsque la position de blocage est atteinte ("position II"). Leur maintien mécanique est alors également assuré.

Enfin, le dispositif selon l'invention permet un enfichage et un désenfichage aisé de la carte de circuit imprimé et de ses composants sans nécessiter d'opérations mécaniques fastidieuses, à la façon d'une glissière à "force d'insertion nulle". On peut noter que dans l'exemple illustré par les figures 3 à 5, le plateau 7 forme également paroi ou couvercle. Il peut être aussi utilisé à des fins de blindage magnétique. Le profil exact du plateau 7 est naturellement adapté à l'utilisation considérée et plus généralement à la forme générale du boîtier que constitue le réceptacle 1. L'ensemble est donc compact et robuste et se prête bien à des applications de type "électronique embarquée". Naturellement le refroidissement peut encore être amélioré en soumettant l'ensemble à une ventilation forcée.

Pour fixer les idées, on peut indiquer qu'un type de circuit magnétique utilisable dans le cadre du dispositif d'alimentation électrique qui vient d'être décrit est celui commercialisé sous les références de la série RM, par la société PHILIPS ; par exemple le type RM5/i.

On pourra utiliser comme mousse la mousse cellulaire étanche grise commercialisée par la société Verneret.

Dans une variante non illustrée, au lieu de prévoir un élément en mousse par circuit magnétique, on pourra disposer une couche de mousse d'épaisseur uniforme entre le plateau 7 et le circuit imprimé 4.

Le joint thermique 2 est constitué par tous moyens conventionnels : tissus, graisse conductrice de la chaleur. Ces moyens sont bien connus et utilisés, par exemple, pour le refroidissement d'élément semi-conducteurs de puissance.

Pour fixer les idées, on peut également indiquer qu'à basse fréquence, à l'air libre, un circuit magnétique, pour une puissance électrique donnée, verrait sa température s'élever d'une valeur typiquement comprise entre 10 et 25°C. Pour les fréquences envisagées dans le cadre de l'invention (1 MHz ou plus) pour la même puissance, l'élévation de température de ce même circuit serait de l'ordre de 50°C à 100°C. En mettant en oeuvre le dispositif de l'invention, on ramènera cette élévation de température dans la gamme 10 à 25°C.

L'invention n'est pas limitée aux variantes de réalisation précisément décrites.

Bien que particulièrement avantageux pour assurer le refroidissement de circuits inductifs utilisant un circuit magnétique à ferrite, le dispositif selon l'invention peut s'appliquer tout autant aux circuits magnétiques de type feuilleté.

On peut également remplacer le circuit imprimé 4 par tout autre support approprié, par exemple de la céramique.

De la même manière, bien que la réalisation des circuits inductifs par métallisation sélective d'un circuit imprimé multicouche soit particulièrement intéressant, il rentre également dans le cadre de l'invention le refroidissement de circuits inductifs à enroulements conventionnels.

Les figures 8 et 9 illustrent schématiquement une variante supplémentaire de réalisation d'un dispositif selon l'invention, dans lequel le circuit inductif est réalisé à l'aide d'un ou plusieurs enroulements conventionnels, enroulements repérés 9.

Le circuit magnétique 3 peut être un pot en ferrite moulé comportant deux parties 30 et 31. Il peut être également réalisé à base d'éléments feuilletés en "U" ou de toute autre manière.

On a également représenté sur les figures deux brides de fixation 32 et 33 permettant l'assemblage.

Conformément à l'une des dispositions essentielles de l'invention, la partie inférieure du circuit magnétique 3 est munie de moyens de répartition de contrainte 6, par exemple une rondelle en mousse. Celle-ci peut être collée sur le circuit magnétique 3.

Contrairement aux dispositifs précédemment décrits, dans cette variante de réalisation, l'ensemble : "bobinage 9 - circuit magnétique 3" est situé d'un seul côté du circuit imprimé 4.

La rondelle en mousse 6 peut à son tour être collée au circuit imprimé 4 pour rendre le circuit magnétique 3 solidaire de celui-ci. Les connexions électriques sont réalisées par soudure de fils souples 90 sur la métallisation supérieure du circuit imprimé 4 ou dans des trous métallisés prévus à cet effet. Si cette disposition n'est pas adoptée, il faudra prévoir des moyens d'ancrage du circuit magnétique 3 au support 4. Ces moyens d'ancrage devront laisser au circuit magnétique 3 un degré de liberté suivant une direction perpendiculaire au support 4.

La figure 8 représente la position d'enfichage/désenfichage ("position I"). La figure 9 représente la position de blocage ("position II").

Les glissières 8 exercent une force de pression, via la plaque 7, sur le circuit imprimé 4 et le bloque dans les rainures de guidage de la structure d'accueil 1. Une seule rainure de guidage 11 a été représentée sur les figures 8 et 9.

Dans cet exemple de réalisation, c'est le circuit imprimé 4 qui va exercer une force de pression sur l'élément 6. Cet élément 6 va se déformer et repartir uniformément cette pression sur la face inférieure du circuit magnétique 3, tout en le soulevant suivant la direction de la flèche Fᵥ. La face supérieure du circuit magnétique 3 rentre alors en contact avec le joint thermique 2.

Il est naturellement nécessaire que le circuit imprimé 4 ait une rigidité suffisante pour exercer la pression sur le ou les circuits magnétiques 3 sans déformations excessives. Pour ce faire, on doit prévoir une épaisseur suffisante ou un renforcement par une plaque rigide. La pièce 7 peut servir à cet effet. En effet, il suffit que la pièce 7 soit plane et et non plus en forme de "U", comme précédemment.

## Revendications

1. Dispositif de refroidissement d'au moins un circuit inductif disposé sur un support (4), ce support étant destiné à être inséré dans un réceptacle (1) comportant des moyens permettant ledit refroidissement (2, 13) ; caractérisé en ce qu'il comprend des moyens commandables (7, 8) exerçant une force de pression sur chaque circuit inductif suivant une direction déterminée (Fᵥ) de manière à l'amener en contact avec une surface déterminée (2) desdits moyens de refroidissement lorsque la pression est exercée et des moyens de répartition de contrainte (6), disposés entre lesdits moyens commandables (7, 8) et chaque circuit inductif, répartissant uniformément la pression sur une portion (3, 10) du circuit inductif.

2. Dispositif selon la revendication 1, caractérisé en ce que le support (4) est constitué par un circuit imprimé comportant au moins une couche de métallisation (401 à 404).

3. Dispositif selon la revendication 2, caractérisé en ce que le circuit imprimé (4) est un circuit imprimé multicouche (41 à 43) et en ce que le bobinage constituant chaque circuit inductif est réalisé par métallisation sélective d'au moins une couche (401 à 404) de ce circuit imprimé et des trous métallisés de jonction.

4. Dispositif selon l'une quelconque des revendications 1 à 3 ; caractérisé en ce que chaque circuit inductif comporte un circuit magnétique (3) en ce que le support (4) comporte une fenêtre (40) aménagée pour chaque circuit magnétique (3, 3a, 3b) permettant un coulissement de celui-ci parallèlement à ladite direction déterminée (Fᵥ) et en ce qu'il comprend des moyens (5) de rappel du circuit magnétique, éloignant celui-ci de la surface déterminée (2) des moyens de refroidissement lorsque ladite pression n'est pas exercée et autorisant l'insertion libre du support (4) dans le réceptable (1).

5. Dispositif selon la revendication 4 ; caractérisé en ce que chaque circuit magnétique (3) est constitué par un pot (30, 31) en ferrite.

6. Dispositif selon la revendication 5, caractérisé en ce que les moyens de rappel (5) sont constitués par un élément en mousse inséré à l'intérieur dudit pot entre le support (4) et une de ses extrémités (35).

7. Dispositif selon l'une quelconque des revendications 1 à 6, caractérisé en ce que les moyens de répartition de contrainte (5) sont constitués par un élément en mousse.

8. Dispositif selon l'une quelconque des revendications 6 ou 7, caractérisé en ce que lesdits éléments en mousse sont constitués par des rondelles.

9. Dispositif selon l'une quelconque des revendications 1 à 8, caractérisé en ce que les moyens commandables exerçant une force de pression sur chaque circuit magnétique (3, 3a, 3b) comprennent une plaque d'un profil déterminé (7) agissant sur les moyens de répartition de contrainte (6) et des moyens (8) de translation de ladite plaque (7) parallèlement à ladite direction déterminée (Fᵥ) ; et en ce que ledit réceptable (1) comporte des rainures de guidage (11, 12) dans lesquelles est inséré, par glissement, l'ensemble constitué du support (4), de la plaque (7) et des moyens de translation (8).

10. Dispositif selon la revendication 9, caractérisé en ce que les moyens de translation (8) sont constitués par des glissières déformables en épaisseur, déplaçant la plaque (7) parallèlement à ladite direction déterminée (Fᵥ) et bloquant cette plaque (7) et le support (4) dans lesdites rainures de guidage (11, 12), après insertion.

11. Dispositif selon l'une quelconque des revendications 1 à 10 ; caractérisé en ce que plusieurs circuits magnétiques (3, 3a, 3b) sont disposés sur le support (4).
